# EUROPEAN PATENT APPLICATION

(11) **EP 4 530 654 A1**
(43) Date of publication of application: **02.04.2025**
(21) Application number: 23200279.0
(22) Date of filing: 28.09.2023
(51) Int. Cl.: G01R 33/3815, H01R 4/68

(54) **CONNECTOR FOR A MAGNETIC RESONANCE EXAMINATION APPARATUS**

(71) Applicant: Koninklijke Philips N.V., 5656 AG Eindhoven (NL)
(72) Inventor: FORTHMANN, Peter, Eindhoven (NL); VERNICKEL, Peter, Eindhoven (NL); LIPS, Oliver, 5656AG Eindhoven (NL); LOESCHER, Stefan Leonhard, Eindhoven (NL)
(74) Representative: Philips Intellectual Property & Standards

(57) **Abstract**

According to the invention, a connector (1) for galvanically connecting a first terminal (2) of a magnetic resonance examination apparatus (4) with a second terminal (5) of the magnetic resonance examination apparatus (4), comprising a first superconductor line (8) with an end region (14) for attaching to the first terminal (2) and an opposite end region (16), a second superconductor line (10) with an end region (14) for attaching to the second terminal (5) and an opposite end region (16), a third superconductor line (12), and a metallic plate element (18) with a first flat surface (20) and a second flat surface (22) on opposite sides thereof, wherein the first superconductor line (8) and the second superconductor line (10) are each attached to the first flat surface (20) of the metallic plate element (18) with their respective opposite end region (16), the shape of the opposite end region (16) of the first superconductor line (8) and the shape of the opposite region (16) of the second superconductor line (10) are both curved shapes, and the third superconductor line (12) is attached to the second flat surface (22) of the metallic plate element (18) wherein the end regions (14, 16) of the third superconductor line (12) also have curved shapes and overlap with the opposite end region (16) of the first superconductor line (8) and with the opposite end region (16) of the second superconductor line (10), respectively. In this way, a robust connector for the magnetic resonance examination apparatus is provided.

## Description

### FIELD OF THE INVENTION

The invention relates to the field of magnetic resonance imaging. In particular, the present invention relates to the field of a connector for a magnetic resonance examination apparatus.

### BACKGROUND OF THE INVENTION

A magnetic resonance examination apparatus uses a main magnetic field to align the nuclear spins of atoms. This main magnetic field is generated by a superconducting static field magnet comprising several coils, in a cryostat in the magnetic resonance examination apparatus. Herein, magnetic resonance examination apparatuses include magnetic resonance imaging apparatuses primarily intended for diagnostic imaging on a patient and nuclear magnetic resonance apparatuses.

To generate the main magnetic field, the static field magnet and thus the coils must be supplied with a current. This current can be provided by an external power supply, which is galvanically connected to the cryostat of the magnetic resonance examination apparatus. To maintain superconductivity of the static field magnet, the cryostat must maintain the temperature required for superconductivity. The operating temperature for common static field magnets, is 4 K for niobium titanium (NbTi) superconductors or 20 K for magnesium diboride (MgB₂) superconductors. This temperature is usually achieved employing liquid helium as a coolant.

In particular, magnesium diboride lends itself to operating in a simplified cryogenic environment, because it allows the construction of conduction cooled coils that require smaller or no amounts of liquid helium than niobium titanium superconductors.

In order to allow a magnetic field as homogeneous as possible in a recess formed in the cryostat, a bore, it is necessary to use several coils galvanically connected to each other. These galvanic connections between the different coils in a magnesium diboride superconducting static magnet are critical parts because they affect a residual resistance and thus the heat generated in the cryostat. Furthermore, they are mechanically more demanding than simple coil windings of the magnesium diboride superconductor in the coils. One option is to make the individual coils from individual wires, which in turn requires making connections that cannot be superconducting. The design of these connectors is critical because they introduce residual resistance and therefore the heat generated in the cryostat should be kept to an absolute minimum. They are also more mechanically demanding than simple coil windings of the magnesium diboride superconductor in the coils.

From WO 2013/114233 A1 a magnetic resonance imaging system comprising a superconducting magnet with a first current lead and a second current lead for connecting to a current ramping system is known. The magnet further comprises a vacuum vessel penetrated by the first current lead and the second current lead. The magnet further comprises a magnet circuit within the vacuum vessel. The magnet circuit has a first magnet circuit connection and a second magnet circuit connection. The magnet further comprises a first switch between the first magnet connection and the first current lead and a second switch between the second magnet connection and the second current lead. The magnet further comprises a first current shunt connected across the first switch and a second current shunt connected across the second switch.

### SUMMARY OF THE INVENTION

It is an object of the invention to provide a robust connector for a magnetic resonance examination apparatus.

According to the invention, this object is addressed by the subject matter of the independent claims. Preferred embodiments of the invention are described in the dependent claims.

Therefore, according to the invention, a connector for galvanically connecting a first terminal of a magnetic resonance examination apparatus with a second terminal of the magnetic resonance examination apparatus is provided, comprising a first superconductor line with an end region for attaching to the first terminal and an opposite end region, a second superconductor line with an end region for attaching to the second terminal and an opposite end region, a third superconductor line, and a metallic plate element with a first flat surface and a second flat surface on opposite sides thereof, wherein the first superconductor line and the second superconductor line are each attached to the first flat surface of the metallic plate element with their respective opposite end region, the shape of the opposite end region of the first superconductor line and the shape of the opposite region of the second superconductor line are both curved shapes, and the third superconductor line is attached to the second flat surface of the metallic plate element wherein the end regions of the third superconductor line also have curved shapes and overlap with the opposite end region of the first superconductor line and with the opposite end region of the second superconductor line, respectively.

The connector can be used to connect an external power supply to a cryostat of the magnetic resonance examination apparatus in order to supply it with power. Likewise, the connector may be used for various different connections in the magnetic resonance examination apparatus. However, it is particularly preferred that the first terminal and the second terminal are used at a first coil and a second coil of the magnetic resonance examination apparatus, respectively, so that the connector connects the first coil to the second coil at the respective terminals. The end regions of the first superconductor line and the second superconductor line can be connected to the first and second terminal by soldering.

According to the invention, it has been recognized that, although magnesium diboride superconductors require little helium and are considered high-temperature superconductors with a operating temperature of 20 K at which they are superconducting, it is the galvanic connections between the coils that are a challenge in setting up the magnetic resonance examination apparatus because of the brittleness of magnesium diboride. Likewise, these connections are space-consuming in the cryostat because a bending radius of the magnesium diboride only allows a connection of two coils with a full spiral winding the size of a coil winding due to the brittleness.

With the connector according to the invention, these problems can be circumvented. Due to the fact that the first to third superconducting lines are connected to each other via the metallic plate element, the first terminal and the second terminal can be connected to each other in a space-saving manner. The superconductor lines can be formed straight, accordingly applied at angles on the metallic plate element, so that they can connect the two terminals with each other in the best possible way. The superconductor lines may already have been prefabricated for the final assembly into the desired shape, since magnesium diboride is only brittle after it is finalized in a reaction process and can still be shaped into any desired form before this.

The feature that the curved end regions of the third superconductor overlap with the opposite end region of the first superconductor line and with the opposite end region of the second superconductor line, respectively, means that these end regions are attached to overlapping areas on opposite sides of the metallic plate element.

By the end regions being curved shapes, the contact area on the metallic plate element is increased, which in turn reduces the contact resistance.

In principle, the curved shapes can be designed in different ways. According to a preferred embodiment of the invention, however, the curved shapes are chosen from meander shapes and coil shapes or a combination thereof. Meander shapes and coil shapes allow for longer attachments (joints) with less extension than for straight shapes, and longer joints reduce the contact resistance.

In general, the metallic plate element can be made of different materials. According to a preferred embodiment of the invention, however, the metallic plate element comprises copper. Copper is an excellent conductor, both thermally and galvanically. This means that the superconductor lines can be thermally coupled to each other to keep temperature losses as low as possible. At the same time, copper is easy to machine and can still be manipulated on site during the assembly of the magnetic resonance examination apparatus.

It is possible to use different superconductors in the superconductor lines. According to a preferred embodiment of the invention, however, the first superconductor line, the second superconductor line and the third superconductor line comprise a high temperature superconductor. Various high-temperature superconductors can be provided for this purpose. According to a preferred embodiment of the invention, however, the high temperature superconductor is MgB₂. The advantage of using a high-temperature superconductor is that it can be more efficiently conduction-cooled than NbTi superconductors, for example, which are preferably surrounded by liquid helium. This avoids the need to introduce liquid helium into the connector to keep it at the superconducting temperature. For this purpose, the high-temperature superconductor may be in the form of high-temperature superconductor strands deposited in a metal matrix, e.g. on a tape, to form the single superconductor line.

In principle, the superconductor lines can be of various shapes. According to a preferred embodiment of the invention, however, middle regions of the superconductor lines which connect the two end regions of the superconductor lines have a straight shape. This prevents breakage due to the brittleness of the superconductor material.

It is possible to galvanically connect the end regions of the superconductors to the metallic plate element in different ways. According to a preferred embodiment of the invention, however, the end regions of the superconductor lines which are attached to the metallic plate element are attached thereto by soldering. The soldering of the end regions onto the metallic plate element enables a simple and efficient assembly of the connector, which can also still be manipulated on site during the insertion of the connector.

In principle, the metallic plate element can be formed in various ways. According to a preferred embodiment of the invention, however, the metallic plate element is comprised of a first sub element, a second sub element and a third sub element, wherein the opposite end region of the first superconductor line is attached to the first sub element, the opposite end region of the second superconductor line is attached to the second sub element, the third superconductor line is completely attached to the third sub element, and the first sub element and the second sub element are both removably attached to the third sub element. The sub elements are preferably designed in such a way that the sides of the sub elements facing each other are flat so that they can be contacted with each other as advantageously as possible. The sides of the sub elements facing away from each other then have the corresponding contacts with the respective superconductor lines. In this way, the connector can be transported in modular form. On site, only the end regions of the first superconductor line and the second superconductor line would then have to be connected to the first and second terminals using a process such as soldering. The other parts of the connector can be contacted to each other with the sub elements.

According to a preferred embodiment of the invention, the metallic plate element is comprised of a first sub element, a second sub element, a third sub element and a fourth sub element, wherein the opposite end region of the first superconductor line is attached to the first sub element, the opposite end region of the second conductor line is attached to the second sub element, one end region of the third superconductor line is attached to the third sub element, the opposite end region of the third superconductor line is attached to the fourth sub element, the first sub element is removably attached to the third sub element, and the second sub element is removably attached to the fourth sub element. This means that longer distances can be covered with the connector. The middle region of the third superconductor line is no longer in contact with the metallic plate element. Changes in a direction in which the connector is laid are intercepted with the sub elements. The bridging of a distance between two coils that are far apart is then made possible with the third superconductor line, which has the corresponding length.

In principle, the sub elements can be connected to each other in various ways. According to a preferred embodiment of the invention, however, the sub elements comprise through-holes through which screws are passed for securing the respective sub elements to each other. Of course, in addition to screws, other fasteners can also be provided that are suitable for connecting the sub elements to the through-holes.

The through-holes may have different shapes. According to a preferred embodiment of the invention, however, the through-holes have an oval shape or a circular shape with greater diameter than necessary for passing the screws. This allows for slight mechanical adjustments.

The invention further concerns a coil assembly for a magnetic resonance examination apparatus comprising a first coil with a first terminal, a second coil with a second terminal and a connector according to any one of the previous claims connecting the coils at the respective terminals to each other.

Further, according to the invention, a magnetic resonance examination apparatus is provided, which comprises a coil assembly as described before.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1a schematically depicts a connector according to a preferred embodiment of the invention in a front view,
Fig. 1b schematically depicts the connector according to a preferred embodiment of the invention in a rear view
Fig. 2a schematically depicts a connector according to another preferred embodiment of the invention in a front view,
Fig. 2b schematically depicts the connector according to another preferred embodiment of the invention in a rear view,
Fig. 3 schematically depicts a connector according to a third preferred embodiment of the invention,
Fig. 4 schematically depicts a coil assembly according to a preferred embodiment of the invention; and
Fig. 5 schematically depicts a magnetic resonance examination apparatus according to a preferred embodiment of the invention.

### DETAILED DESCRIPTION OF EMBODIMENTS

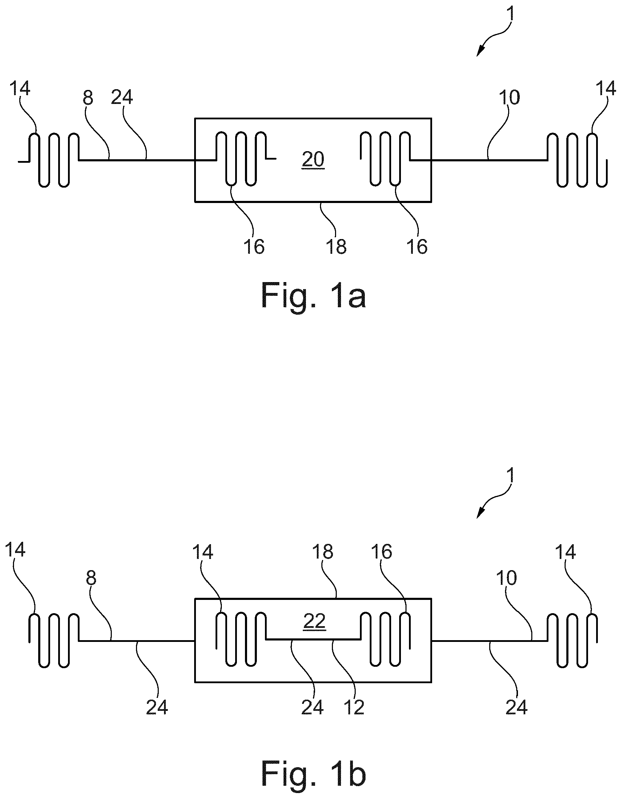

Fig. 1a schematically shows a connector 1 according to a preferred embodiment of the invention in a front view. The connector 1 has a first superconductor line 8 and a second superconductor line 10. Both superconductor lines 8, 10 each comprise an end region 14 and an opposite end region 16. The first superconductor line 8 and the second superconductor line 10 extend from the end regions 14 with straight middle regions 24 to the opposite end regions 16. The end regions 14 and the opposite end regions 16 are meandering. The opposite end regions 16 are soldered to a first flat surface 20 of a metallic plate element 18.

Fig. 1b schematically shows the connector 1 according to a preferred embodiment of the invention in a rear view. A third superconductor line 12 is arranged on a second flat surface 22 arranged opposite the first flat surface 20 of the metallic plate element 18. Analogous to the first and second superconductor lines 8, 10, the third superconductor line 12 also extends from an end region 14 to an opposite end region 16, with the end region 14 of the third superconductor line 12 on the second flat surface 22 overlapping with the opposite end region 16 of the first superconductor line 8 on the first flat surface 20. Accordingly, the opposite end region 16 of the third superconductor line 12 on the second flat surface 22 overlaps with the opposite end region 16 of the second superconductor line 10 on the first flat surface 20. This allows a current to be transmitted through the metallic plate element 18 between the end regions 14, 16. Along the metallic plate element 18, however, this current is transmitted with the third superconductor line 12. The overlap through the metallic plate element 18 between the respective end regions 14, 16 ensures the lowest possible contact resistance in the metallic plate element 18. The first, second and third superconductor lines 8, 10, 12 are preferably formed with magnesium diboride as a high-temperature superconductor. Furthermore, the metallic plate element 18 is preferably a copper plate. The design of the connector 1 chosen here avoids exceeding a bending radius of the magnesium diboride superconductor. The straight middle regions 24 take this brittleness of the material into account.

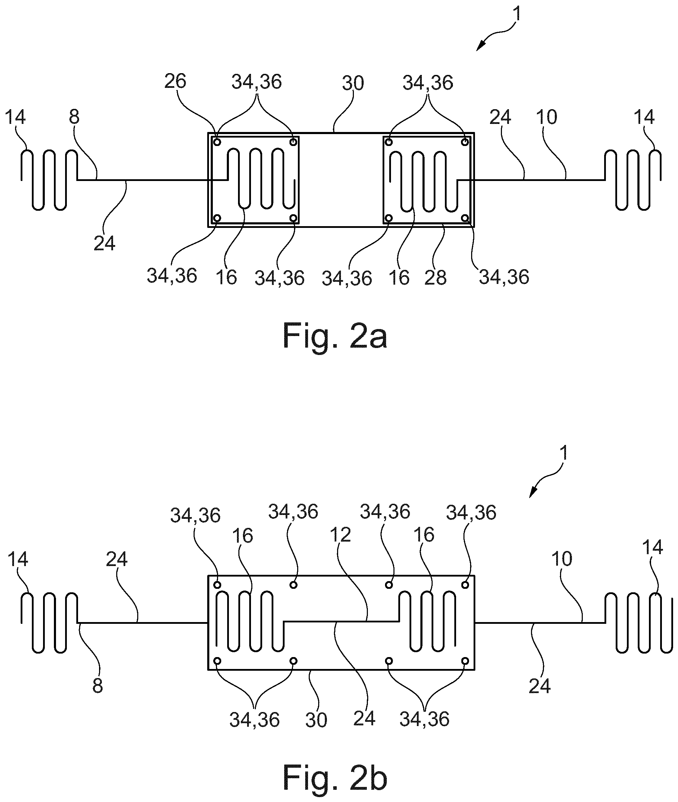

Fig. 2a schematically shows a connector 1 according to a further preferred embodiment of the invention in a front view. In this embodiment, the metallic plate element 18 has a first sub element 26, a second sub element 28 and a third sub element 30. The first sub element 26 and the second sub element 28 are provided with through-holes 34, through which the respective sub elements 26, 28 are connected to the third sub element 30, which also has through-holes 34, with corresponding screws 36. The opposite end region 16 of the first superconductor line 8 is soldered to the side of the first sub element 26 facing away from the third sub element 30. The opposite end region 16 of the second superconductor line 10 is soldered to the side of the second sub element 28 facing away from the third sub element 30. The sides of the sub elements facing each other are flat to enable the most advantageous contacting.

Fig. 2b schematically shows the connector 1 according to a further preferred embodiment of the invention in a rear view. Analogously to Fig. 1b, the third superconductor line 12 is applied to a side of the third sub element 30 facing away from the first sub element 26 and the second sub element 28. An essential feature of the embodiment shown in Figs. 2a and 2b is the modular structure of the connector 1. The first superconductor line 8 is soldered to the first sub element 26 and can thus be attached to the third sub element 30 with screws 36. The same applies to the second superconductor line 10 soldered to the second sub element 28.

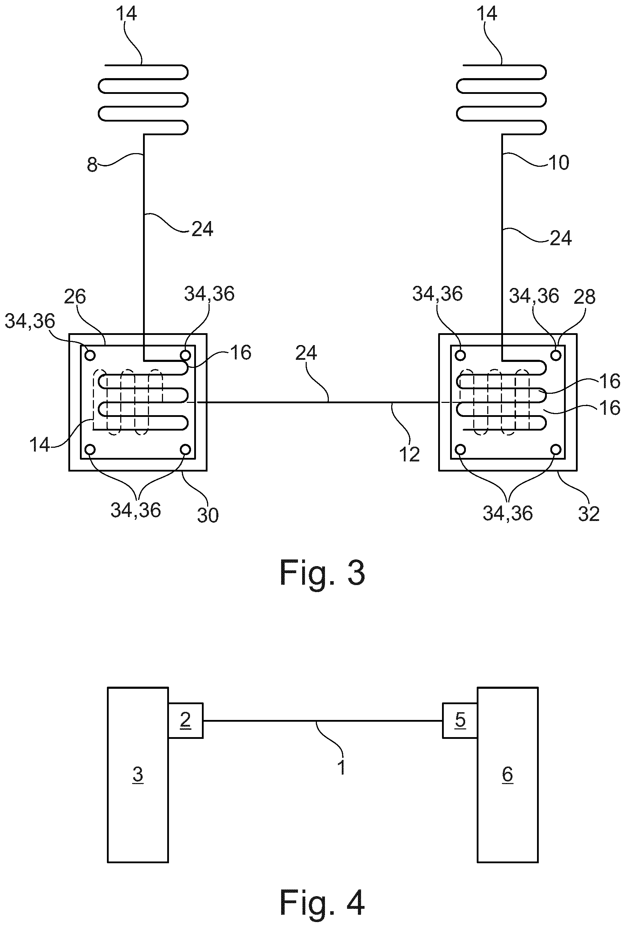

Fig. 3 schematically shows a connector according to a third preferred embodiment of the invention. Analogous to the embodiment shown in Figs. 2a and 2b, the first superconductor line 8 is soldered to the first sub element 26. The second superconductor line 10 is soldered to the second sub element 28. However, the first and second sub elements 26, 28 are now screwed to a third and fourth sub element 30, 34 provided with through-holes 34 with screws 36. The third sub element 30 is screwed to the first sub element 26, the fourth sub element 32 is screwed to the second sub element 28. The third and fourth sub elements 30, 32 are shown enlarged in Fig. 3, but this does not necessarily have to be the case. Rather, these sub elements 30, 32 can also be designed to be congruent with the respective first and second sub elements 26, 28. The third superconductor line 12 is indicated by dashed lines in a translucent view. The end region 14 of the third superconductor line 12 is soldered on the side of the third sub element 30 facing away from the first sub element 26. The opposite end region 16 of the third superconductor line 12 is soldered on the side of the fourth sub element 32 facing away from the second sub element 28. The middle region 24 of the third superconductor line thus no longer has any contact with the metallic plate element 18. With this embodiment of the invention, in particular, further spaced terminals 2, 5 can be galvanically contacted with each other.

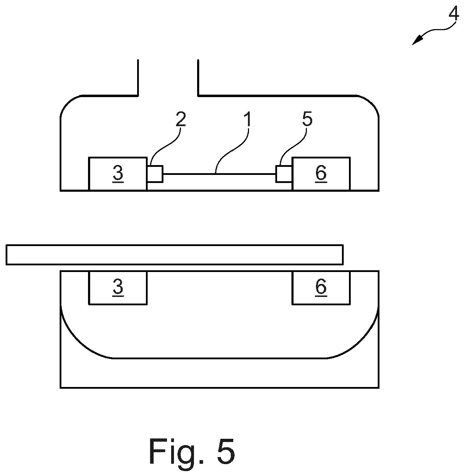

Such a situation is given, for example, in Fig. 4. Here a coil assembly according to a preferred embodiment of the invention is shown schematically. In this case, the connector 1 galvanically connects a first coil 3 provided with a first terminal 2 to a second terminal 5 of a second coil 6. More precisely, the end regions 14 of the first superconductor line 8 and the second superconductor line 10 of the connector 1 can make galvanic contact on the one hand with the first terminal 2 and the second terminal 5. For contacting with the terminals 2, 5 shown in Figs. 4 and 5, the end regions 14 of the first superconductor line 8 and the second superconductor line 10 are soldered to these.

Fig. 5 schematically depicts a magnetic resonance examination device 4 with the coil assembly of Fig. 4 according to a preferred embodiment of the invention.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| Connector | 1 |
| first terminal | 2 |
| first coil | 3 |
| magnetic resonance examination apparatus | 4 |
| second terminal | 5 |
| second coil | 6 |
| first superconductor line | 8 |
| second superconductor line | 10 |
| third superconductor line | 12 |
| end region | 14 |
| opposite end region | 16 |
| metallic plate element | 18 |
| first flat surface | 20 |
| second flat surface | 22 |
| middle region | 24 |
| first sub element | 26 |
| second sub element | 28 |
| third sub element | 30 |
| fourth sub element | 32 |
| through-hole | 34 |
| screw | 36 |

## Claims

1. Connector (1) for galvanically connecting a first terminal (2) of a magnetic resonance examination apparatus (4) with a second terminal (5) of the magnetic resonance examination apparatus (4), comprising
a first superconductor line (8) with an end region (14) for attaching to the first terminal (2) and an opposite end region (16),
a second superconductor line (10) with an end region (14) for attaching to the second terminal (5) and an opposite end region (16),
a third superconductor line (12), and
a metallic plate element (18) with a first flat surface (20) and a second flat surface (22) on opposite sides thereof, wherein
the first superconductor line (8) and the second superconductor line (10) are each attached to the first flat surface (20) of the metallic plate element (18) with their respective opposite end region (16),
the shape of the opposite end region (16) of the first superconductor line (8) and the shape of the opposite region (16) of the second superconductor line (10) are both curved shapes, and
the third superconductor line (12) is attached to the second flat surface (22) of the metallic plate element (18) wherein the end regions (14, 16) of the third superconductor line (12) also have curved shapes and overlap with the opposite end region (16) of the first superconductor line (8) and with the opposite end region (16) of the second superconductor line (10), respectively.

2. Connector (1) according to claim 1, wherein the curved shapes are chosen from meander shapes and coil shapes or a combination thereof.

3. Connector (1) according to claim 1 or 2, wherein the metallic plate element (18) comprises copper.

4. Connector (1) according to any one of the preceding claims, wherein the first superconductor line (8), the second superconductor line (10) and the third superconductor line (12) comprise a high temperature superconductor.

5. Connector (1) according to claim 4, wherein the high temperature superconductor is MgB₂.

6. Connector (1) according to any one of the preceding claims, wherein middle regions (24) of the superconductor lines (8, 10, 12) which connect the two end regions (14, 16) of the superconductor lines (8, 10, 12) have a straight shape.

7. Connector (1) according to any one of the preceding claims, wherein the end regions (14, 16) of the superconductor lines (8, 10, 12) which are attached to the metallic plate element (18) are attached thereto by soldering.

8. Connector (1) according to any one of the preceding claims, wherein the metallic plate element (18) is comprised of a first sub element (26), a second sub element (28) and a third sub element (30), wherein
the opposite end region (16) of the first superconductor line (8) is attached to the first sub element (26),
the opposite end region (16) of the second superconductor line (10) is attached to the second sub element (28),
the third superconductor line (12) is completely attached to the third sub element (30), and
the first sub element (26) and the second sub element (28) are both removably attached to the third sub element (30).

9. Connector (1) according to any one of the claims 1 to 7, wherein the metallic plate element (18) is comprised of a first sub element (26), a second sub element (28), a third sub element (30) and a fourth sub element (32), wherein
the opposite end region (16) of the first superconductor line is attached to the first sub element (26),
the opposite end region (16) of the second conductor line is attached to the second sub element (28),
one end region (14, 16) of the third superconductor line (12) is attached to the third sub element (30),
the opposite end region (16) of the third superconductor line (12) is attached to the fourth sub element (32),
the first sub element (26) is removably attached to the third sub element (30), and
the second sub element (28) is removably attached to the fourth sub element (32).

10. Connector (1) according to claim 8 or 9, wherein the sub elements (26, 28, 30, 32) comprise through-holes (34) through which screws (36) are passed for securing the respective sub elements (26, 28, 30, 32) to each other.

11. Connector (1) according to claim 10, wherein the through-holes (34) have an oval shape or a greater diameter than necessary for passing the screws (36).

12. Coil assembly for a magnetic resonance examination apparatus (4) comprising a first coil (3) with a first terminal (2), a second coil (6) with a second terminal (5) and a connector (1) according to any one of the previous claims connecting the coils (3, 6) at the respective terminals (2, 5) to each other.

13. Magnetic resonance examination apparatus (4) with a coil assembly according to claim 12.
